# EUROPEAN PATENT APPLICATION

(11) **EP 4 796 947 A1**
(43) Date of publication of application: **26.08.2026**
(21) Application number: 25159080.8
(22) Date of filing: 20.02.2025
(51) Int. Cl.: G01R 33/3415, G01R 33/36

(54) **RADIO-FREQUENCY RECEIVER FOR MAGNETIC RESONANCE IMAGING**

(71) Applicant: Koninklijke Philips N.V., 5656 AE Eindhoven (NL)
(72) Inventor: HUANG, Yiyi, Eindhoven (NL); ZHANG, Wei, Eindhoven (NL); GAO, Xiaoyang, Eindhoven (NL); LIU, Mao, Eindhoven (NL); XU, Qilin, Eindhoven (NL); YE, Shun, Eindhoven (NL)
(74) Representative: Philips Intellectual Property & Standards

(57) **Abstract**

Disclosed herein is an MRI radio-frequency receiver (100) with a connector module (112) for receiving multiple MRI coils (104, 106, 108) with a cumulative maximum of M coil elements.

The radio-frequency receiver comprises a receiver module (114) comprising N independent receive channels for digitizing MRI signals and receiving channel tune-detune (DT) signals (418) for controlling the coil elements. M is larger than N. The radio-frequency receiver comprises a controllable RF switching network (116) for routing radio-frequency signals from the coil elements to the independent receive channels. The radio-frequency receiver comprises a tune-detune module (118) for providing coil element specific tune-detune signals. Machine executable instructions (120) cause a computational system (110) to: control (200) the controllable RF switching network to perform the routing using a radio-frequency switching configuration table (124); and control (202) the tune-detune module to generate coil element specific tune-detune signals using a tune-detune configuration table (126).

## Description

### TECHNICAL FIELD

The invention relates to magnetic resonance imaging, in particular to radio-frequency receivers for magnetic resonance imaging systems.

### BACKGROUND

A large static magnetic field is used by Magnetic Resonance Imaging (MRI) scanners to align the nuclear spins of atoms as part of the procedure for producing images within the body of a subject. This large static magnetic field is referred to as the B0 field or the main magnetic field. In MRI, the atomic spins are manipulated using gradient magnetic fields and radio frequency (RF) pulses. As the atomic spins relax, they emit radio-frequency signals which could be referred to as MRI signals. A radio-frequency receiver is used to digitize these MRI signals. This acquired data is referred to a k-space data. This k-space data may be collected and then a transform, such as an inverse Fourier transform, may be used to reconstruct the magnetic resonance image.

United States patent application publication US2009267601A1 discloses a device for magnetic resonance imaging of a body placed in a stationary and substantially homogeneous main magnetic field comprising a main magnet for generation of a stationary and substantially homogeneous main magnetic field within the examination zone. In order to provide an MR device which is arranged to allow for massive parallel imaging without extensive cabling between the individual receiving coils and the back end electronics, the invention proposes to make provision for a plurality of receiving units placed in or near the examination zone, which receiving units each comprise a receiving antenna for receiving MR signals from the body, a digitizing means for sampling the received MR signals and for transforming the signal samples into digital signals, and a transmitter for transmitting the digital signals to a central processing unit. Further, the device comprises synchronization means for synchronizing the operation of the individual digitizing means of the receiving units.

### SUMMARY

The invention provides for a radio-frequency receiver, a magnetic resonance imaging system, a method of operating a radio-frequency receiver, and a computer program product in the independent claims. Embodiments are given in the dependent claims.

In one aspect a radio-frequency receiver for a magnetic resonance imaging system is disclosed. The radio-frequency receiver comprises a connector module operable for receiving multiple MRI coils. The connector module is configured for connecting to a cumulative maximum of M coil elements of the MRI coils. The radio-frequency receiver further comprises a receiver module comprising N independent receive channels configured for digitizing MRI signals for a local controller of the magnetic resonance imaging system. The receive channel module is further configured for receiving channel tune-detune (DT) signals for controlling the coil elements from the local controller of the magnetic resonance imaging system. M is larger than N.

The radio-frequency receiver further comprises a controllable RF switching network for independently routing radio-frequency signals from the M coil elements of the multiple MRI coils to the N independent receive channels. The radio-frequency receiver further comprises a tune-detune module for providing coil element-specific tune-detune signals to the connector module. The radio-frequency receiver further comprises a memory storing machine-executable instructions, a radio-frequency switching configuration table, and a tune-detune configuration table. The radio-frequency receiver further comprises a computational system. Execution of the machine-executable instructions causes the computational system to control the controllable RF switching network to perform the routing using the radio-frequency switching configuration table. Execution of the machine-executable instructions further causes the computational system to control the tune-detune module to generate coil element-specific tune-detune signals using the tune-detune configuration table to match routing of the radio-frequency signals.

In another aspect, a magnetic resonance imaging system comprising an example of the radio-frequency receiver is disclosed. The magnetic resonance imaging system further comprises an example of the multiple MRI coils connected to the connector module. The magnetic resonance imaging system further comprises the local controller connected to the receiver module.

In another aspect, a method of operating a radio-frequency receiver for a magnetic resonance imaging system is disclosed. The radio-frequency receiver comprises a connector module operable for receiving multiple MRI coils. The connector module is configured for connecting to a cumulative maximum of M coil elements of the multiple MRI coils. The radio-frequency receiver further comprises a receiver module comprising N independent receive channels configured for digitizing MRI signals for a local controller of the magnetic resonance imaging system. The receive channel module is further configured for receiving channel tune-detune signals for controlling the coil elements from the local controller of the magnetic resonance imaging system. M is larger than N. The radio-frequency receiver further comprises a controllable RF switching network for independently routing radio-frequency signals from the M coil elements of the multiple MRI coils to the N independent receive channels.

The radio-frequency receiver further comprises a controllable RF switching network for independently routing radio-frequency signals from the M coil elements of the multiple MRI coils to the N independent receive channels. The radio-frequency receiver further comprises a tune-detune module for providing coil element-specific tune-detune signals to the connector module. The method comprises controlling the controllable RF switching network to perform the routing using a radio-frequency switching configuration table. The method further comprises controlling the tune-detune module to generate coil element-specific tune-detune signals using a tune-detune configuration table to match routing of the radio-frequency signals.

In another aspect, a computer program product comprising a computer-readable storage medium having machine-executable instructions embodied therewith is disclosed. The machine-executable instructions are configured to implement an example of the method of operating a radio-frequency receiver for a magnetic resonance imaging system.

### BRIEF DESCRIPTION OF THE DRAWINGS

In the following preferred embodiments of the invention will be described, by way of example only, and with reference to the drawings in which:
Fig. 1 illustrates an example of a radio-frequency receiver.
Fig. 2 shows a flow chart which illustrates a method of using the radio-frequency receiver of Fig. 1
Fig. 3 illustrates and example of a magnetic resonance imaging system.
Fig. 4 shows a functional view of a radio-frequency receiver.
Fig. 5 shows a flow chart which illustrates a method of using the radio-frequency receiver of Fig. 4
Fig. 6 illustrates the use of the coil type detection table, the serial data connection control table, and the attention report table.
Fig. 7 illustrates the use of the malfunction logic table.
Fig. 8 illustrates the use of the radio-frequency switching configuration table and the tune-detune configuration table.

### DESCRIPTION OF EMBODIMENTS

Like numbered elements in these Figures are either equivalent elements or perform the same function. Elements which have been discussed previously will not necessarily be discussed in later Figures if the function is equivalent.

In one example there is a radio-frequency receiver for a magnetic resonance imaging system. A radio-frequency receiver is used in magnetic resonance imaging systems to receive the radio-frequency signals or MRI signals that are generated by a subject during a magnetic resonance imaging system examination. Typically, one or more receive coils or antennas would be connected to the radio-frequency receiver which then digitizes the signals and sends this to the magnetic resonance imaging system. The digitized radio-frequency signals or MRI signals is known commonly as k-space data. During a magnetic resonance imaging examination, the k-space data is collected and then may be used to perform an inverse Fourier transform to reconstruct a magnetic resonance image.

The radio-frequency receiver comprises a connector module operable for receiving multiple MRI coils. The connector module may be the physical vectors that multiple MRI coils are able to be plugged into. Very often MRI coils will have multiple coil elements that function independently. As one of the MRI coils is connected the various elements of the MRI coil are then provided connections via the connector module. The connector module is configured for connecting the cumulative maximum of M coil elements of the multiple MRI coils. For example, the multiple MRI coils each have a number of coil elements. The cumulative total of all the coil elements for all of the multiple MRI coils has a cumulative maximum of M.

The radio-frequency receiver further comprises a receiver module comprising N independent receive channels configured for digitizing MRI signals for a local controller of the magnetic resonance imaging system. The receive channels may take different forms in different examples. In some examples the receive channel may be a radio receiver coupled with a digitizer. For example, in some examples there may be some down conversion before digitization occurs. In other examples the analogue-to-digital converter may be able to receive the MRI signals directly. The MRI signals are the radio-frequency signals received from a particular coil element of one of the MRI coils.

The receive channel module is further configured for receiving channel tune-detune signals for controlling the coil elements from the local controller of the magnetic resonance imaging system. When magnetic resonance imaging is performed it is advantageous to have the receive coil detuned from the resonant frequency. This for example prevents the transmitter or transmitting antenna from dumping radio-frequency energy into the receive coil. Typically, the magnetic resonance imaging system will manipulate the orientation of spins by a combination of time varying gradient magnetic fields and time varying amounts of radio-frequency energy. During a receive phase when the MRI signals are measured to acquire the k-space data, the receive channels are then tuned to the proper frequency. The channel tune-detune signals are used for tuning or detuning the entire magnetic resonance imaging coil.

The radio-frequency receiver further comprises a controllable RF switching network for independently routing radio-frequency signals from the M coil elements of the multiple MRI coils to the N independent receive channels. As was mentioned above, there are more coil elements than there are receive channels N. The controllable RF switching network therefore enables some of the M coil elements to be flexibly routed to the N independent receive channels.

The radio-frequency receiver further comprises a tune-detune module for providing coil element-specific tune-detune signals to the connector module. Above it was described how the receive channel module is configured for receiving channel tune-detune signals. The channel tune-detune signals are tune-detune signals which are provided for a particular receive channel. In some instances, this may be a tune-detune that is provided for an entire antenna. The tune-detune module enables the channel tune-detune signals to be provided at the connector module for specific coil elements of the multiple MRI coils.

The radio-frequency receiver further comprises a memory storing machine-executable instructions, a radio-frequency switching configuration table, and a tune-detune configuration table. The radio-frequency switching configuration table is a table which provides control for the controllable RF switching network to properly route the signals from the connector module to the receiver module channels. The tune-detune configuration table provides a mapping from the receiving channel tune-detune signals to the coil element-specific tune-detune signals provided by the tune-detune module at the connector module.

The radio-frequency receiver further comprises a computational system. Execution of the machine-executable instructions causes the computational system to control the controllable RF switching network to perform the routing using the radio-frequency switching configuration table. Execution of the machine-executable instructions further causes the computational system to control the tune-detune module to generate coil element-specific tune-detune signals using the tune-detune configuration table to match routing of the radio-frequency signals. This example may be beneficial because it may provide a means of flexibly routing and using the various coil elements and multiple MRI coils in a receiver that has fewer receive channels than there are coil elements of the multiple MRI coils.

In another example, the computational system is a CPLD chip. A CPLD chip is a complex programmable logic device. In this example, the CPLD chip comprises the memory storing the various tables and the machine-executable instructions. An advantage of using a CPLD chip is that it provides for complex control of the radio-frequency receiver while operating at a lower power requirement than other solutions such as using an FPGA or microcontroller. Often, the radio-frequency receiver may be operated using battery power or other means. It may be advantageous for the power consumption and heat generation of the radio-frequency receiver to be reduced. The use of a CPLD chip may enable this.

In another example, execution of the machine executable instructions further causes the computational system to receive the channel tune-detune signals from the receiver module. In some examples this may be performed using a fiber optic connection. Execution of the machine executable instructions further causes the computational system to look up RF switching network commands in the radio-frequency switching configuration table using the channel tune-detune signals. Execution of the machine executable instructions further causes the computational system to control the controllable RF switching network with the RF switching network commands to perform the routing. Execution of the machine executable instructions further causes the computational system to look up tune-detune module commands in the tune-detune configuration table using the channel tune-detune signals. Execution of the machine executable instructions further causes the computational system to control the tune-detune module with the tune-detune module commands to generate the coil element specific tune-detune signals. The use of the channel tune-detune signals to control the configuration may provide for an efficient means of providing this control without additional control signals or communication channels needing to be provided.

In another example, the memory further stores a coil type detection table type table and a serial data connection control table. The radio-frequency receiver further comprises a serial data connection switching matrix for routing a coil-specific serial data connection from the connector module to the receiver module. The coil type detection table may for example be used to determine a coil type of the multiple MRI coils plugged into a connector module. The serial data connection control table may be used for routing the serial data connection between the connector module and the receiver module. The serial data connection may for example be used to provide an identifier such as a serial number of a particular MRI coil.

Execution of the machine-executable instructions further causes the computational system to receive coil-specific type detection signals from the connector module in response to the multiple MRI coils being connected to the connector module. The coil-specific type detection signals may for example be voltage signals or may be predetermined connections between various pinout of the connector. This may be used to provide a code which uniquely identifies the type or topology of a particular MRI coil.

Execution of the machine-executable instructions further causes the computational system to determine independent coil types of the MRI coils by performing lookup operations in the coil type detection table using the coil-specific type detection signals. This feature may be particularly advantageous because the coil types of the MRI coils may be determined independently.

Execution of the machine-executable instructions further causes the computational system to generate serial data connection switching matrix control signals by looking up the individual coil types in the serial data connection control table. Execution of the machine-executable instructions further causes the computational system to control the serial data connection switching matrix using the serial data connection switching matrix control signals. Execution of the machine-executable instructions further causes the computational system to transfer the coil-specific type detection signals to the receiver module to match the routing of the radio-frequency signals. This example may be beneficial because it may provide for a means of connecting the multiple coil elements to the various receive channels of the receiver module.

In another example, the coil-specific serial data connection is a one-wire data connection. The use of one-wire may be beneficial because it may provide for a very effective means of transmitting identifying data such as serial number data of a magnetic resonance imaging coil in the magnetic resonance imaging environment.

In another example, the memory further stores an attention report table. Execution of the machine-executable instructions further causes the computational system to look up attention control signals in the attention report table using the independent coil types of the MRI coils. Execution of the machine-executable instructions further causes the computational system to provide attention signals to a receiver module using the attention control signals. The receiver module may send the attention signals to the local controller. In response to the attention signals, the local controller may generate the tune-detune signals based on the detected coil types and scan task. A scan task may be for example a particular clinical mode or it may be a magnetic resonance imaging protocol or a combination of protocols that will be performed to acquire k-space data and ultimately generate magnetic resonance images.

In another example, the radio-frequency receiver further comprises a malfunction detection circuit that is configured to detect a functional status of each coil element of the multiple MRI coils. The malfunction detection circuit may measure one or more electrical parameters or characteristics of a MRI coil element to test it. The memory further stores a malfunction logic table.

Execution of the machine executable instructions causes the computational system to determine the functional status of each coil element of the multiple MRI coils using the malfunction detection circuit. Execution of the machine-executable instructions further causes the computational system to look up malfunction control signals in the malfunction log table using the functional status of each coil element. Execution of the machine-executable instructions further causes the computational system to provide the malfunction control signals to the receiver module to match the routing of the radio-frequency signals. Along with routing the radio-frequency signals, this example may provide a means of enabling the detection of bad coil elements of individuals MRI coils. In another example, execution of the machine-executable instructions further causes the computational system to receive configuration commands that are configured to adjust usage of the coil elements of the multiple MRI coils from the local controller of the magnetic resonance imaging system.

Execution of the machine-executable instructions further causes the computational system to modify the radio-frequency switching configuration table using the configuration commands. Execution of the machine-executable instructions further causes the computational system to update the configuration of the radio-frequency receiver using the modified radio-frequency switching configuration table. The radio-frequency receiver is controlled by various tables. By modifying the contents of the radio-frequency switching configuration table the configuration or various combinations of MRI coils can be adjusted or changed.

In another example, adjusting the usage of the coil elements comprises any one of the following: a change in routing of the coil elements to the independent receive channels, a selective disconnecting of some of the multiple coil elements, a clinical configuration of the multiple MRI coils, and combinations thereof. This for example may be useful in changing the topology of the coils used when acquiring images using the MRI system.

In another example, the multiple MRI coils are at least three MRI coils.

In another example, the multiple MRI coils are at least four MRI coils.

In another example, the multiple MRI coils comprise at least two of the following: a head MRI coil, a Litton MRI coil, an 8-channel MRI coil, a 16-channel MRI coil, and a 24-channel MRI coil. This example may be advantageous because the radio-frequency receiver is flexible and allows different types of magnetic resonance imaging coils to be plugged into the receiver module. In many existing systems they are not able to use more than one type of MRI coil at a time.

In another aspect, there is a magnetic resonance imaging system. The magnetic resonance imaging system comprises an example of the radio-frequency receiver as described above. The magnetic resonance imaging system further comprises multiple MRI coils that are connected to the connector module. The magnetic resonance imaging system further comprises the local controller connected to the receiver module. This example may be beneficial because it may provide for a magnetic resonance imaging system that is flexibly able to use different types of magnetic resonance imaging coils simultaneously.

In another example, the local controller is configured to receive a selection of a clinical mode. The local controller is further configured to generate the channel tune-detune signals according to the independent coil types and the clinical mode. The local controller is further configured to provide the generated tune-detune signals to the connector module. This additional functionality may be beneficial in enabling the magnetic resonance imaging system to provide better control of multiple types of magnetic resonance coils.

In another example, the multiple MRI coils comprise any one of the following: a head MRI coil, a Litton MRI coil, an 8-channel MRI coil, a 16-channel MRI coil, a 24-channel MRI coil, and multiples and/or combinations thereof. This example may be beneficial because the ability to have multiple of or more than one type of MRI coil enables more flexible imaging of the subject.

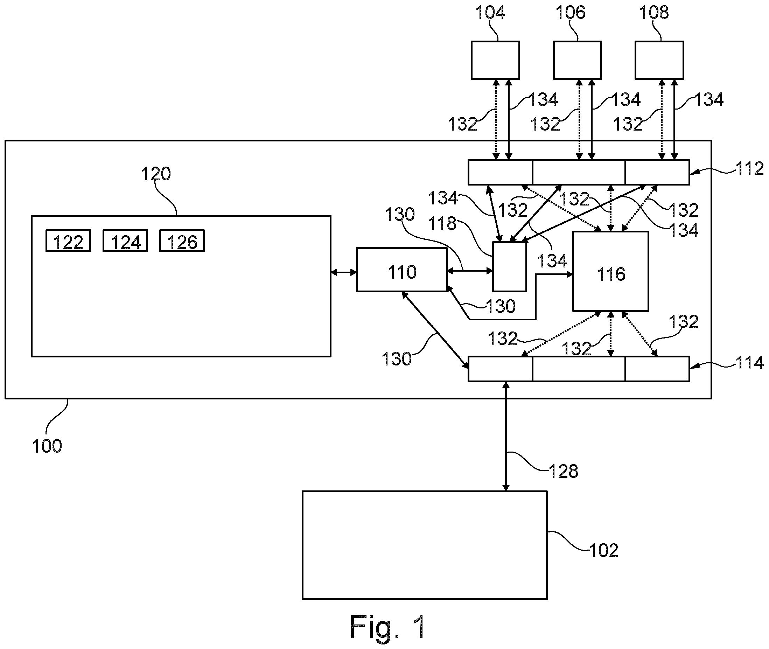

Fig. 1 illustrates a radio-frequency receiver 100 connected to a local controller 102 of a magnetic resonance imaging system and a number of magnetic resonance imaging coils 104, 106, and 108. In this example there are three MRI coils 104, 106, 108 shown as being connected. The system is flexible and is able to connect to different types of MRI coils. 104 represents an MRI coil of type A, 106 represents a MRI coil of type B, and 108 represents a MRI coil of type C.

The radio-frequency receiver 100 comprises a computational system 110 that is in communication with a connector module 112, a receiver module 114, a controllable RF switching network 116, a tune-detune module 118, and a memory 120. The memory 120 is intended to represent various types of memory which are accessible to the computational system 110. In some examples the memory 120 may be a non-transitory storage medium.

The local controller 102 is shown as being connected to the receiver module 114 via a data communication line 128. In many instances this will be a fiber optic connection and will be two-way. The local controller 102 could, for example, send commands to the radio-frequency receiver 100 via the receiver module 114 and may receive digitized radio-frequency signals or k-space data from the receiver module 114. The receiver module may therefore provide an interface to the receiver 100 and may also contain individual radio-frequency channels or receivers that are analogue-to-digital converters for digitizing radio-frequency signals. The receiver module 114 is shown as being broken into multiple channels.

The memory 120 is shown as storing machine-executable instructions 122 that enable the computational system 110 to control the operation and function of the radio-frequency receiver 100. The memory 120 is further shown as containing a radio-frequency switching configuration table 124 that may be used to look up controls for controlling the controllable RF switching network 116. The memory 120 is also shown as containing a tune-detune configuration table 126. The tune-detune configuration table 126 contains a table for looking up data for controlling the tune-detune module 118.

In some examples, the computational system 110 may receive data about tuned or detuned signals received from the local controller (channel tune-detune signals). The computational system 110 would then use the tune-detune configuration table 126 to control the tune-detune module 118 to send tune-detune signals 134 to the MRI coils 104, 106, 108 via the connector module 112. The channel tune-detune signals may also be used to look up a configuration for the controllable RF switching network 116 in the radio-frequency switching configuration table 124.

The dashed lines 132 represent one or more RF transmission lines. For example, the RF transmission lines between the MRI coils 104, 106, 108 represent multiple RF coils as these may be multi-element MRI coils. The connector module 112 feeds to the controllable RF switching network 116 and the signals from individual coil elements are routed to individual channels in the receiver module 114. The configuration of the controllable RF switching network 116 is controlled with the radio-frequency switching configuration table 124.

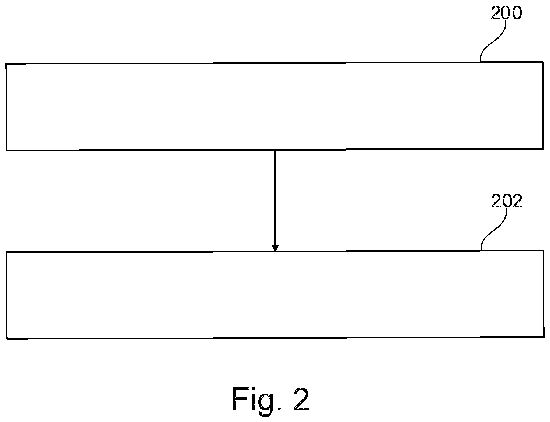

Fig. 2 shows a flowchart which illustrates a method of operating the radio-frequency receiver 100 of Fig. 1. In step 200, the controllable RF switching network 116 is controlled to perform the routing of RF signals from the MRI coils 104, 106, 108 to the receiver module 114 using the radio-frequency switching configuration table 124. In step 202, the tune-detune module 118 is controlled to generate coil element-specific tune-detune signals using the tune-detune configuration table 126.

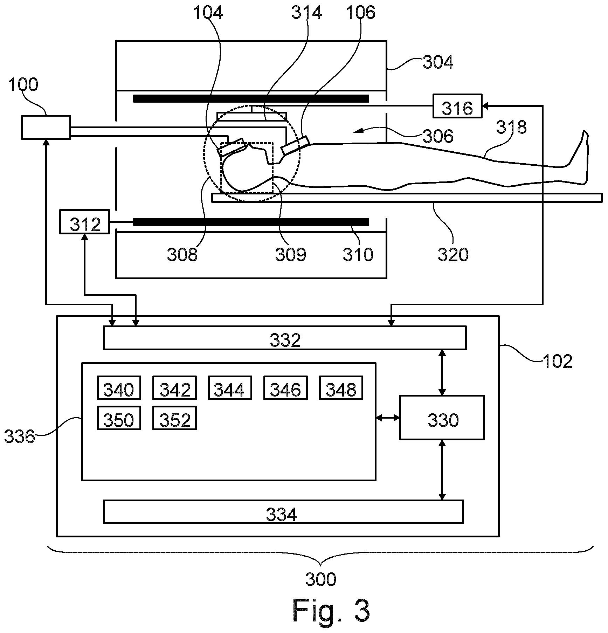

Fig. 3 illustrates an example of a magnetic resonance imaging system 300 that incorporates the radio-frequency receiver 100 of Fig. 1. The magnetic resonance imaging system 300 is shown as comprising a magnet 304, a computer 102, and the radio-frequency receiver 100.

The magnetic resonance imaging system 300 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

There is a magnetic resonance imaging transmit coil 314 that is connected to a transmitter 316. Additionally, the radio-frequency receiver 100 is shown as being connected to an MRI coil of type A 104 and an MRI coil of type B 106. For example, the MRI coil of type A 104 could be a head coil and the MRI coil of type B 106 could be a surface coil. Both coils are only shown as being partially within the field of view 309. The radio-frequency receiver 100 is flexible enough that it can use coil elements selectively from the two coils 104, 106. Coils which are not relevant for measuring the field of view 309 may for example be disabled in favor of other coil elements.

The magnetic resonance imaging system 302 is shown as being controlled by a computer system (local controller) 102. The local controller is shown as comprising a processor 330 which may represent one or more processors or computational system located at one or more locations. The processor 330 is further shown as being in communication with a hardware interface 332, and optional user interface 334, and a memory 336. The hardware interface 332 of the local controller 102 that is shown as being connected to the radio-frequency receiver 100, the magnetic field gradient coil power supply 312, and the transmitter 316.

The memory 336 is shown as containing local machine-executable instructions 340. The local machine-executable instructions enable the processor 330 to perform such tasks as controlling the magnetic resonance imaging system 300 as well as performing numerical and image processing tasks. The memory 336 is further shown as containing pulse sequence commands 342. The pulse sequence commands are commands or data which may be converted into commands, which control the various components of the magnetic resonance imaging system 300 including the radio-frequency receiver 100. The memory 336 is further shown as containing k-space data 334 that was acquired by controlling the magnetic resonance imaging system with the pulse sequence commands 342. The memory 336 is further shown as containing a magnetic resonance image 346 that was reconstructed from the k-space data 344.

The memory 336 is further shown as optionally containing configuration commands 348. The configuration commands 348 may be sent to the radio-frequency receiver 100 to amend or change the contents of the various tables 124, 126. This may be one way of updating or modifying the behavior of the radio-frequency receiver 100.

The memory 336 is also shown as optionally containing a selection of a clinical mode 350 and optional channel tune-detune signals 352. The clinical mode 350 may be used to control the local controller such that it generates the channel tune-detune signals 352. The channel tune-detune signals 352 can then be provided to the radio-frequency receiver 100 to control the tuning and detuning of various coil elements during execution of the pulse sequence commands 342.

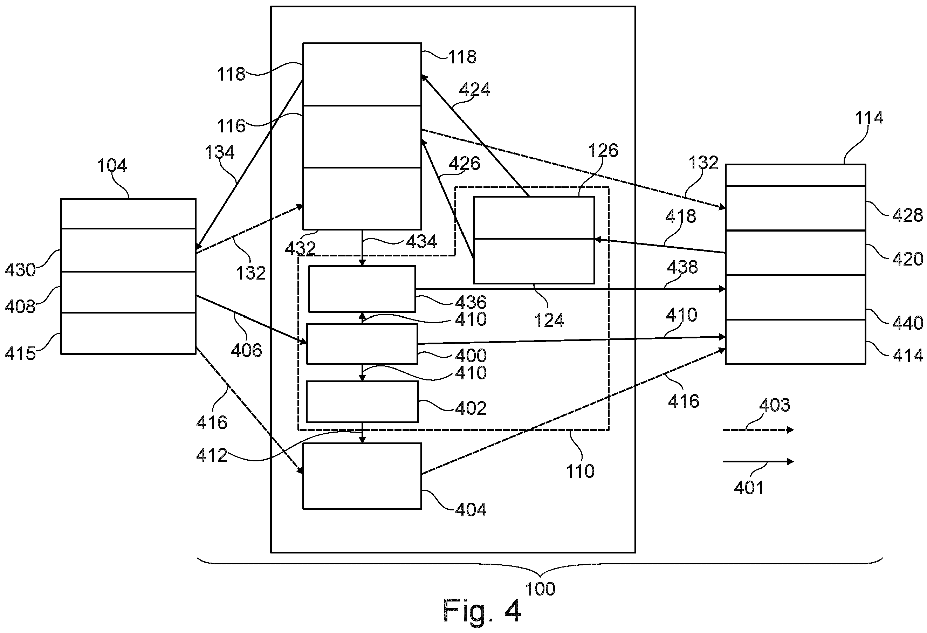

Fig. 4 shows the functional view of one example of the radio-frequency receiver 100. The connector module 112 is not shown in this Figure. A single coil 104 is shown as being connected to the radio-frequency receiver 100. Likewise, only a single channel of the receiver module 114 is shown. The dashed lines 401 represent signal lines where signals are transmitted and the solid lines 403 represent control lines.

The radio-frequency receiver 100 is shown as comprising a coil type detection table 400, a serial data connection control table 402, and a serial data connection switching network 404. From the magnetic resonance imaging coil 104 there is a coil detect signal 408 that provides coil-specific type detection signals 406. These are then fed to the coil type detection table 400. This then produces independent coil types 410 that are provided to the serial data connection control table 402 and the malfunction logic table 436. The independent coil types 410 are also sent to a coil detect interface 414 on the receiver 114. The receiver module 114 may also be referred to as RXE4 in this and the following Figures. A dash after REX4 followed by a number, such as RXE4-1 or RXE4-2, refers to a particular channel of the receiver module 114.

The serial data connection control table 402 uses the independent coil types 410 to look up a serial data connection switching matrix controls 412 that control the serial data connection switching network 404 to route serial data 416 from a serial data source 415 of the MRI coil 104 to the coil detect interface 414 of the receiver 114. The coil-specific type detection signals 406 may be used to determine the particular type of magnetic resonance imaging coils and the serial data 416 may be used to identify specific coils, for example a serial number. The receiver module 114 has a tune-detune interface 420 to receive channel tune-detune signal 418 from the local controller 102.

In this example, the channel tune-detune signal 418 is used as a look up in the radio-frequency switching configuration table 124 and the tune-detune configuration table 126. This is used to provide the element-specific tune-detune signal 424 that is sent to the tune-detune module and to generate the RF switching network commands 426 that are used to control the configuration of the controllable RF switching network 116. In addition to or as an alternative, the independent coil types 410 can also be used as part of the look up in controlling the tune-detune configuration table 126 and the radio-frequency switching configuration table 124. When the controllable RF switching network 116 is configured the coil RF elements 430 or the MRI coil 104 can have their RF signal routed along the RF transmission lines 132 to the analogue-to-digital converter module 428 of the receiver 114 via the switching network 116.

The tune-detune module 118 may then receive the element-specific tune-detune signal 424 and use this to generate the tune-detune signal 134 that is provided to the individual coil RF elements 430 of the magnetic resonance imaging antenna 104. The malfunction detection circuit 432 can also test the individual RF coil elements 432 via the RF transmission line 132. It may then provide a functional status data 434 that is used to look up malfunction control signals 438 in the malfunction logic table 436 with the independent coil types to provide the functional status of individual coil elements. The malfunction control signals 438 may then be provided via the malfunction report interface 440 of the individual channels of the receiver module 114.

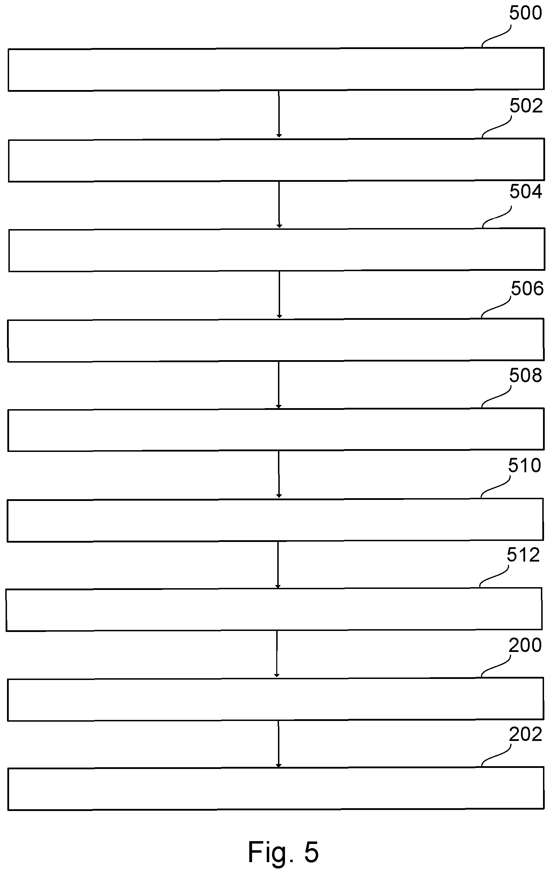

Fig. 5 shows a flowchart which illustrates a method of operating the radio-frequency receiver 100 of Fig. 4. The functionality illustrated in Fig. 4 and described in Fig. 5 may also be incorporated into the radio-frequency receiver 100 as depicted in Figs. 1 and 3.

In step 500, coil-specific type detection signals 406 are received from the connector module 112. In response to the multiple MRI coils 104, 106, 108 being connected to the connector module 112. In step 502, the independent coil types 410 of the MRI coils 104, 106, 108 are determined by performing look up operations in the coil type detection table 400. This is performed using a look up operation using the coil-specific type detection signals 406. In step 504, the serial data connection switching matrix control signals 412 are generated by looking up the individual coil types 410 in the serial data connection control table 402. In step 506, the serial data connection switching matrix 404 is controlled using the serial data connection switching matrix controls 412. In step 508, the coil-specific detection signals 410 are transferred to the receiver module 114 to match the routing of the radio-frequency signals. In step 510, the RF switching network commands 426 are looked up in the radio-frequency switching configuration table using the channel tune-detune signals 418. In step 512, the tune-detune module commands 424 are looked up in the tune-detune configuration table 126 using the channel tune-detune signals 418 also. Steps 200 and 202 are then performed as was illustrated in Fig. 2. The RF switching network commands are used in step 200 and the tune-detune module commands are used in step 202.

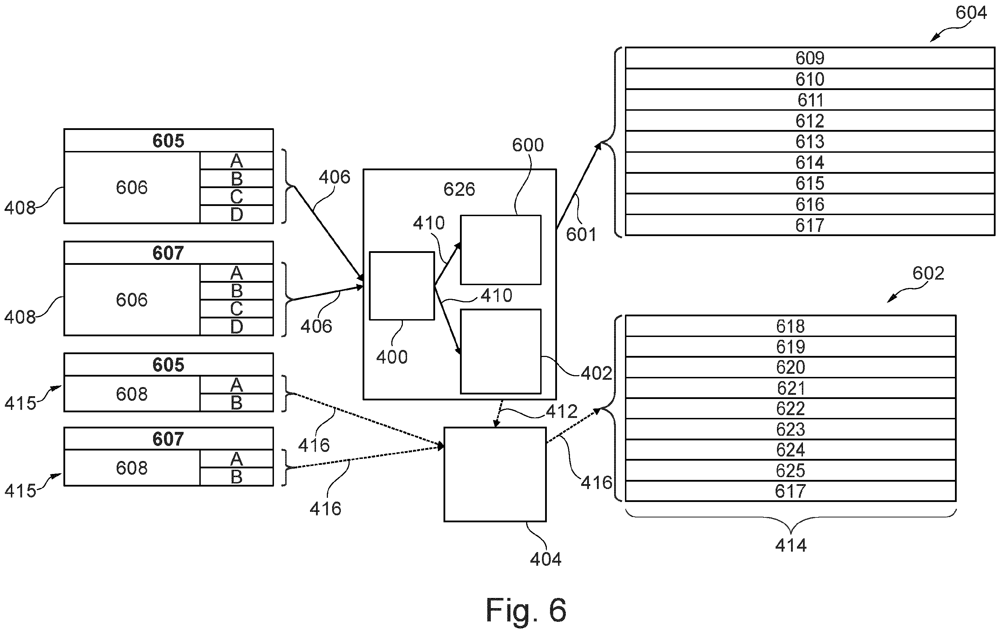

Fig. 6 represents the functionality of the routing for the coil connector detect signals and the serial data source 415 from several different magnetic resonance imaging coils 104, 106, 108. The coil-specific type detection signals 406 from two different coils 408 are routed to the coil type detection table 400. This is then used to look up the independent coil types 410 which are provided to the serial data connection control table 402 and the attention report table 600. The output of the attention report table are attention control signals 601 which are provided in the attention signal interface on the receiver module 604 and the independent coil types 410 are used in the serial data connection control table 402 to provide serial data connection switching matrix controls 412 which control the serial data connection switching network 404. This routes the serial data 416 from the serial data source 415 of the coils to the serial data interface on the receiver module 602. Effectively 604 and 602 form the coil detect 414 as illustrated in Fig. 4.

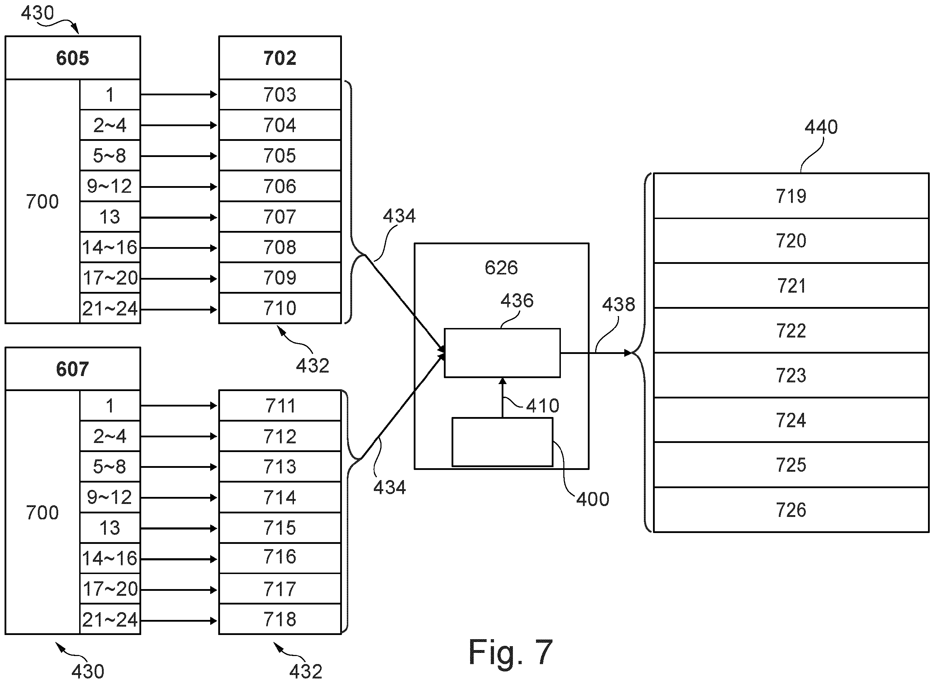

Fig. 7 illustrates the coil malfunction functionality. The individual coil elements 430 are connected to the malfunction detection circuits 432 individually. The results of these are then fed to the malfunction logic table 436 which performs a look up of the malfunction control signals 438 using both the functional status data 434 and the independent coil types 410. The malfunction control signals 438 of the individual coil elements are then provided at the malfunction report interface 440.

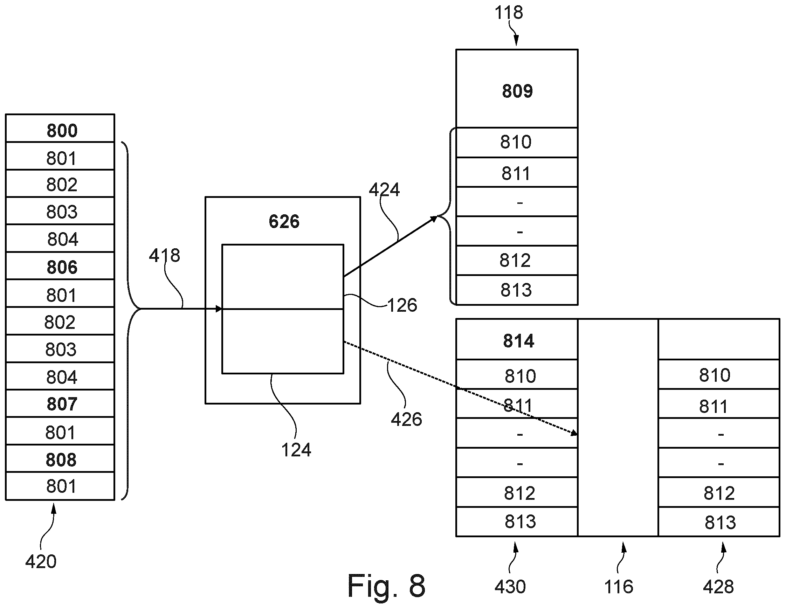

Fig. 8 illustrates the control of the tune-detune module 118 and the radio-frequency switching matrix 116. The tune-detune interface 420 receives the channel tune-detune signals and this is then fed to the radio-frequency switching configuration table 124 and the tune-detune configuration table 126. The tune-detune configuration table 126 uses the channel tune-detune signal 418 to look up the tune-detune module commands and control the tune-detune module 118. Likewise, the radio-frequency switching configuration table 124 uses the channel tune-detune signals 418 to look up the RF switching network commands 426 to control the controllable RF switching network 116. This then routes radio-frequency signals from the individual coil elements 430 to the individual analogue-to-digital converter modules 428.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium" as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage" or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational systems to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator. A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, WLAN connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, television screen, touch screen, tactile electronic display, Braille screen, Cathode Ray Tube (CRT), storage tube, bi-stable display, electronic paper, vector display, flat panel display, Vacuum Fluorescent (VD) display, Light-Emitting Diode (LED) displays, Electro-Luminescent Display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

100 radio-frequency receiver
102 local controller of magnetic resonance imaging system
104 MRI coil of type A
106 MRI coil of type B
108 MRI coil of type C
110 computational system
112 connector module
114 receiver module
116 controllable RF switching network
118 tune-detune module
120 memory
122 machine executable instructions
124 radio-frequency switching configuration table
126 tune-detune configuration table
128 data communication line (fiber optic)
130 data communication
132 RF transmission line
134 element specific tune-detune signal
200 control the controllable RF switching network to perform the routing using the radio-frequency switching configuration table
202 control the tune-detune module to generate coil element specific tune-detune signals using the tune-detune configuration table to match routing of the radio-frequency signals
300 magnetic resonance imaging system
304 magnet
306 bore of magnet
308 imaging zone
309 field of view
310 magnetic field gradient coils
312 magnetic field gradient coil power supply
314 transmit MRI coil
316 transmitter
318 subject
320 subject support
330 processor
332 hardware interface
334 user interface
336 memory
340 local machine executable instructions
342 pulse sequence commands
344 k-space data
346 magnetic resonance image
348 configuration commands (to modify tables)
350 selection of clinical mode
352 channel tune-detune signals
400 coil type detection table
401 signal line
402 serial data connection control table
403 control line
404 serial data connection switching network
406 coil specific type detection signals
408 coil connector detect signal
410 independent coil types
412 serial data connection switching matrix control signals
414 coil detect on receiver module
415 serial data source
416 serial data
418 channel tune-detune signals
420 tune-detune interface
424 tune-detune module commands
426 RF switching network commands
428 ADC
430 individual coil element
432 malfunction detection circuit
434 functional status data
436 malfunction logic table
438 malfunction control signals
440 malfunction report interface
500 receive coil specific type detection signals from the connector module in response to the multiple MRI coils being connected to the connector module
502 determine independent coil types of the MRI coils by performing lookup operations in the coil type detection table using the coil specific type detection signals
504 generate serial data connection switching matrix control signals by looking up the individual coil types in the serial data connection control table
506 control the serial data connection switching matrix using the serial data connection switching matrix control signals
508 transfer the coil specific type detection signals to the receiver module to match routing of the radio-frequency signals
510 look up RF switching network commands in the radio-frequency switching configuration table using the coil specific type detection signals
512 look up tune-detune module commands in the tune-detune configuration table using the coil specific type detection signals
600 attention report table
601 attention control signals
602 serial data interface on receiver module
604 attention signal interface on receiver module
605 Coil connector-1
606 Detect Signal
607 Coil connector-2
608 One wire
609 RXE4-1 Attention signal 1 for 8 channel coil-1
610 RXE4-1 Attention signal 2 for 8 channel coil-2
611 RXE4-2 Attention signal 1 for 16 channel coil-1
612 RXE4-2Attention signal 2 for 16 channel coil-2
613 RXE4-3 Attention signal 1 for 24 channel coil-1
614 RXE4-3 Attention signal 2 for 24 channel coil-2
615 RXE4-4 Attention signal 1 for Litton coil-1
616 RXE4-4 Attention signal 2 for Litton coil-2
617 Restriction mode
618 RXE4-1 one-wire 1 for 8 channel coil-1
619 RXE4-1 one-wire 2 for 8 channel coil-2
620 RXE4-2 one-wire 1 for 16 channel coil-1
621 RXE4-2 one-wire 2 for 16 channel coil-2
622 RXE4-3 one-wire 1 for 24 channel coil-1
623 RXE4-3 one-wire 2 for 24 channel coil-2
624 RXE4-4 one-wire 1 for Litton coil-1
625 RXE4-4 one-wire 2 for Litton coil-2
626 Logic table (firmware in CPLD chip)
700 RF channel
702 Malfunction detect circuit
703 Group 1a
704 Group 2a
705 Group 3a
706 Group 4a
707 Group 5a
708 Group 6a
709 Group 7a
710 Group 8a
711 Group 1b
712 Group 2b
713 Group 3b
714 Group 4b
715 Group 5b
716 Group 6b
717 Group 7b
718 Group 8b
719 RXE4-1 malfunction signal for 8 channel coil -1
720 RXE4-2 malfunction signal for 8 channel coil -2
721 RXE4-1 malfunction signal for Litton coil -1
722 RXE4-2 malfunction signal for Litton coil -2
723 RXE4-2 malfunction signal for 16 channel coil -1
724 RXE4-3 malfunction signal for 16 channel coil -2
725 RXE4-2 malfunction signal for 24 channel coil -1
726 RXE4-5 malfunction signal for 24 channel coil -2
800 RXE4-1
802 detune (DT) signal 1
803 DT signal 2
804 DT signal 3
805 DT signal 4
806 RXE4-2
807 RXE4-3
808 RXE4-4
809 Coil loops tune/detune circuits
810 Loop 1
811 Loop 2
812 Loop 63
813 Loop 64
814 Coil connector

## Claims

1. A radio-frequency receiver (100) for a magnetic resonance imaging system (300), the radio-frequency receiver comprising:
- a connector module (112) operable for receiving multiple MRI coils (104, 106, 108), wherein the connector module is configured for connecting to a cumulative maximum of M coil elements of the multiple MRI coils;
- a receiver module (114) comprising N independent receive channels configured for digitizing MRI signals for a local controller (102) of the magnetic resonance imaging system, wherein the receive channel module is further configured for receiving channel tune-detune (DT) signals (418) for controlling the coil elements from the local controller of the magnetic resonance imaging system, wherein M is larger than N;
- a controllable RF switching network (116) for independently routing radio-frequency signals from the M coil elements of the multiple MRI coils to the N independent receive channels;
- a tune-detune module (118) for providing coil element specific tune-detune signals to the connector module;
- a memory (120) storing machine executable instructions and a radio-frequency switching configuration table (124) and a tune-detune configuration table (126);
- a computational system (110), wherein execution of the machine executable instructions causes the computational system to:
- control (200) the controllable RF switching network to perform the routing using the radio-frequency switching configuration table; and
- control (202) the tune-detune module to generate coil element specific tune-detune signals using the tune-detune configuration table.

2. The radio-frequency receiver of claim 1, wherein the computational system is a CPLD chip, and wherein the CPLD chip comprises the memory.

3. The radio-frequency receiver of claim 1 or 2, wherein execution of the machine executable instructions further causes the computational system to:
- receive the channel tune-detune signals from the receiver module;
- look up (510) RF switching network commands (426) in the radio-frequency switching configuration table using the channel tune-detune signals;
- control (200) the controllable RF switching network with the RF switching network commands to perform the routing;
- look up (512) tune-detune module commands (424) in the tune-detune configuration table using the channel tune-detune signals; and
- control (202) the tune-detune module with the tune-detune module commands to generate the coil element specific tune-detune signals.

4. The radio-frequency receiver of claim 1, 2, or 3, wherein the memory further stores a coil type detection table (400) and a serial data connection control table (402), wherein the radio-frequency receiver further comprises a serial data connection switching matrix (404) for routing a coil specific serial data connection from the connector module to the receiver module; wherein execution of the machine executable instructions further causes the computational system to:
- receive (500) coil specific type detection signals (406) from the connector module in response to the multiple MRI coils being connected to the connector module;
- determine (502) independent coil types (410) of the MRI coils by performing lookup operations in the coil type detection table using the coil specific type detection signals;
- generate (504) serial data connection switching matrix control signals (412) by looking up the individual coil types in the serial data connection control table;
- control (506) the serial data connection switching matrix using the serial data connection switching matrix control signals; and
- transfer (508) the coil specific type detection signals to the receiver module to match routing of the radio-frequency signals.

5. The radio-frequency receiver of claim 4, wherein the coil specific serial data connection is a one-wire data connection.

6. The radio-frequency receiver of claim 4 or 5, wherein the memory further stores an attention report table (600), wherein execution of the machine executable instructions further causes the computational system to:
- look up attention control signals (601) in the attention report table using independent coil types of the MRI coils; and
- provide attention signals to the receiver module using the attention control signals.

7. The radio-frequency receiver of any one of the preceding claims, wherein the memory further stores a malfunction logic table 436, wherein the radio-frequency receiver further comprises a malfunction detection circuit (432) configured to detect a functional status (434) of each coil element of the multiple MRI coils, wherein execution of the machine executable instructions further causes the computational system to:
- determine the functional status of each coil element of the multiple MRI coils using the malfunction detection circuit;
- look up malfunction control signals (438) in the malfunction log table using the functional status of each coil element; and
- provide the malfunction control signals to the receiver module.

8. The radio-frequency receiver of any one of the preceding claims, wherein execution of the machine executable instructions further causes the computational system to:
- receive configuration commands (348) configured to adjust usage of the coil elements of the multiple MRI coils from the local controller of the magnetic resonance imaging system;
- modify the radio-frequency switching configuration table using the configuration commands; and
- update configuration of the radio-frequency receiver using the modified radio-frequency switching configuration table.

9. The radio-frequency receiver of claim 8, wherein adjusting usage of the coil elements comprises any one of the following: a change in routing of the coil elements to the independent receive channels, a selective disconnecting of some of the multiple coil elements, a clinical configuration of the multiple MRI coils, and combinations thereof.

10. The radio-frequency receiver of any one of the preceding claims, wherein the multiple MRI coils comprise at least two of the following: a head MRI coil, a Litton MRI coil, an 8 channel MRI coil, a 16 channel MRI coil, and a 24 channel MRI coil.

11. A magnetic resonance imaging system (300) comprising:
- the radio-frequency receiver (100) of any one of claims 1 through 10;
- the multiple MRI coils (104, 106, 108) connected to the connector module (112); and
- the local controller (102) connected to the receiver module.

12. The magnetic resonance imaging system of claim 11, the local controller is configured to:
- receive a selection of a clinical mode (350);
- generate the channel tune-detune signals (352) according to the independent coil types and the clinical mode;
- provide the generated channel tune-detune signals to the connector module.

13. The magnetic resonance imaging system of claim 11 or 12, wherein the multiple MRI coils comprise any one of the following: a head MRI coil, a Litton MRI coil, an 8 channel MRI coil, a 16 channel MRI coil, a 24 channel MRI coil, and multiple and/or combinations thereof.

14. A method of operating a radio-frequency receiver (100) for a magnetic resonance imaging system (300), the radio-frequency receiver (100) comprising:
- a connector module (112) operable for receiving multiple MRI coils (104, 106, 108), wherein the connector module is configured for connecting to a cumulative maximum of M coil elements of the multiple MRI coils;
- a receiver module (114) comprising N independent receive channels configured for digitizing MRI signals for a local controller (102) of the magnetic resonance imaging system, wherein the receive channel module is further configured for receiving channel tune-detune (DT) signals (418) for controlling the coil elements from the local controller of the magnetic resonance imaging system, wherein M is larger than N;
- a controllable RF switching network (116) for independently routing radio-frequency signals from the M coil elements of the multiple MRI coils to the N independent receive channels; and
- a tune-detune module (118) for providing coil element specific tune-detune signals to the connector module;
wherein the method comprises:
- controlling (200) the controllable RF switching network to perform the routing using a radio-frequency switching configuration table (124); and
- controlling (202) the tune-detune module to generate coil element specific tune-detune signals using a tune-detune configuration table (126).

15. A computer program product comprising a computer-readable storage medium (120) having machine executable instructions (122) embodied therewith, said machine executable instructions are configured to implement the method of claim 14.
